Europäisches Patentamt

European Patent Office

Office européen des brevets

(11) Publication number: 0 591 733 A1

# EUROPEAN PATENT APPLICATION

(21) Application number: 93114961.1

(22) Date of filing: 16.09.93

(51) Int. Cl.5: H01L 21/48, H05K 3/46

(30) Priority: 21.09.92 JP 251016/92

(43) Date of publication of application:
13.04.94 Bulletin 94/15

(84) Designated Contracting States:
DE GB

(71) Applicant: MATSUSHITA ELECTRIC
INDUSTRIAL CO., LTD.
1006, Oaza Kadoma
Kadoma-shi, Osaka-fu, 571(JP)

(72) Inventor: Nakatani, Seiichi
11-29-16, Kourigaoka
Hirakata City 573(JP)
Inventor: Yuhaku, Satoru
3-5-5, Tsuruhashi,
Ikuno-ku
Osaka City 544(JP)
Inventor: Hakotani, Yasuhiko
2351, Najio,
Shiose-cho
Nishinomiya City 669-11(JP)
Inventor: Itagaki, Minehiro
16-3, Dainichi-higashimachi
Moriguchi City 570(JP)

(74) Representative: Dr. Elisabeth Jung Dr. Jürgen
Schirdewahn Dipl.-Ing. Claus Gernhardt
Postfach 40 14 68
D-80714 München (DE)

(54) Method for producing multilayered ceramic substrate.

(57) Ceramic green sheets are laminated on both faces of a glass-ceramic green sheet laminate to become the substrate, and the assemblage is fired in such a temperature range that the glass-ceramic powder in the laminate is sintered and the ceramic powder in the ceramic green sheet is not sintered, and the resultant substrate shrinks only in a thickwise direction during the firing while maintaining the original size in planar direction.

FIG.2

Production process flow

Glass-ceramic green sheet — Printing
Glass-ceramic green sheet — Printing — Alumina green sheet
Glass-ceramic green sheet — Printing
Laminating — Firing — Removing alumina sheet — Printing top layer conductor — Firing — Finish

## FIELD OF THE INVENTION AND RELATED ART STATEMENT

### 1. FIELD OF THE INVENTION

The present invention relates to a method for producing a multilayered ceramic substrate for use in mounting and interconnecting electronic components such as semiconductor LSIs and chip components.

### 2. DESCRIPTION OF THE RELATED ART

In recent years, thanks to development of a low temperature firing glass-ceramic multilayered substrate, gold, silver, copper, palladium or mixtures thereof are used as conductive materials. The above-mentioned metals have a low conductor resistance as compared with tungsten, molybdenum and the like high melting point metals used hitherto. Therefore, when using such metals as conductive material of multilayered ceramic substrate, the substrate can be produced at low cost with a high safety of a firing furnace or the like equipments.

Meanwhile, among these metals, gold, silver and palladium are noble metals and are expensive, and further susceptive to wide price fluctuations. Therefore, it is desirable to use a copper electrode material which is less expensive and stable in price.

Hereupon, one example of the typical process of producing the low temperature firing multilayered substrate is described. The process of producing the low temperature firing multilayered substrate can be roughly classified into three processes.

First, silver is used in an internal electrode of the multilayered substrate, by laminating a desired number of green sheets of the low temperature firing substrate and fired in air, followed by printing silver-palladium pastes on a top layer for firing. In this process, silver having a low impedance is used as inner electrodes. Therefore, the silver-palladium having a certain heat resistance to solder are used in the top layer.

As a second process, the silver is used in the internal electrode similarly as the first process, but copper is used for the top layer wiring. Then, as compared with the first process using silver-palladium for the top layer wiring, this second process is superior in the points of low impedance and good solderability. However, since eutectic temperature of the copper used in the top layer with silver is low, a low temperature firing copper paste with a firing temperature of about 600°C must be used. As a result, it has a problem in the adhesion strength and solderability. For example, Japanese Patent Publication No. H03-78798 shows the above-mentioned second process.

Finally, as a third process, copper electrodes are used in the inner layer and the top layer. This process is the best with respect to the conductor resistance, solderability and cost, but the firing has to be performed all in an inert gas atmosphere like nitrogen gas. So this process is unpracticable. In general, when using the copper electrode, a wiring pattern is formed on the substrate by screen-printing using a copper paste, and after drying, the printed copper paste is subjected to firing in a nitrogen atmosphere. In the firing, an oxygen partial pressure is suppressed so that copper is not oxidized and the organic components in the conductor paste are burnt sufficiently at the temperature (about 850°C to 900°C) below the melting point of copper. In the case of multilayered structure, a dielectric layer is printed on the above substrate followed by firing under the same condition (Japanese Laid-Open Patent Publication No. S57-53321).

However, it is difficult to control the atmosphere in the firing process at an adequate oxygen partial pressure, and in case of lamination, whenever the pastes are printed, the firing must be repeated, thus a lead time is prolonged and the cost of equipments and the like is increased. Therefore, in Japanese Patent Publication No. H03-20914, there is disclosure of a process that in producing the multilayered ceramic substrate, a cupric oxide paste is used and three steps of binder burn-out process, reduction process and firing process are adopted. In the process, a laminate of green sheets with conductor pastes using cupric oxide as a starting material of the conductor is produced, and then the binder burn off process is carried out in a sufficient oxygen atmosphere and at a sufficient temperature to thermally decompose the organic binder in the conductor pastes.

Next, the process is accomplished by reduction process for reducing cupric oxide into copper followed by firing process for sintering the substrate. Thereby, the atmospheric control during the firing is simplified and a densely sintered substrate is obtained.

On the other hand, low temperature firing substrate materials are usually fired at a temperature of about 850°C to 1000°C, because it must be fired below the melting points of the aforementioned metal materials. In general, as such low temperature firing substrate materials there are a glass-ceramic composite type, a crystallized glass type, a ceramic composite type and the like. Among these three types of materials, the most used is the glass-ceramic composite type material which contains a ceramic filler and crystallized glass combined. The reason is that, in the glass-ceramic composite type, the substrate having various characteristics (thermal expansion, thermal conductivity, dielectric constant etc.) can be obtained by selecting compositions of the glass and types of the filler.

Usually, a mixing ratio of the glass to alumina serving as the ceramic filler is about 50 wt%, and the mixed material is sintered at a low temperature of from 850°C to 900°C. In the sintering process, first, the glass particles start to be softened and form a network with the alumina particles, and then, crystallizing reactions take place at an interface of the glass and alumina, thereby making the dense sintered substrate. The control of particle size distribution and dispersibility with alumina particles of the glass particles are key points for stable production. The production processes and substrate materials are now about to develop a low temperature fired substrate to be used as a high density wiring substrate, which corresponds to future small-sized and high frequency electronic equipments.

However, the ceramic multilayered substrate involves the following problems.

That is, the ceramic multilayered substrate tends to shrink by sintering during firing. Shrinkages by the sintering differ from each other depending on the substrate materials, green sheet compositions and powder lots, which are used. Thereby several problems are encountered in the production of the multilayered substrate.

First, the top layer wiring is formed after firing the internal wiring as mentioned in the above in producing the multilayered ceramic substrate. Therefore, when shrinkage error of the substrate is large, the wiring pattern of the top layer and the internal electrode can not be connected owing to the dimensional errors. For this reason, a land of unnecessarily large area must be formed at the electrode portion of the top layer so as to allow the shrinkage errors. Thus, this type of the substrate can not be used in a circuit requiring the high density wiring. As another conventional measure, there is such a process that several screen patterns of different sizes of the top layer wiring are preliminarily prepared for various shrinkages after firing, and that some of them is selected for screen-printing electrode/wiring on respective top layers of differently shrinking substrate. In such conventional process, a number of different sizes screen pattern must be prepared, and thus it is uneconomical.

When the firing of the top layer wiring is performed simultaneously with the firing of the internal layer, the large land is not necessary. However the shrinkage errors of the substrate per-se remain as it is even by this simultaneous firing process. Therefore, in printing of a solder paste at the final components mounting, there may be such case that printing can not be made on necessary portions because of the errors. Also in mounting the components practically, there may be a discrepancy from the holes or connectors located at predetermined positions of the components.

Secondly, in the multilayered substrate made by the green sheet laminating process, the shrinkages in X-direction and Y-direction on the plane of substrate differ from each other depending on doctor blading direction of the green sheet. This also hinders production of the ceramic multilayered substrate.

In order to decrease the shrinkage errors to a level as low as possible, the production process must be controlled sufficiently, not only on the substrate materials and green sheet compositions, but also on the difference in powder lots and the laminating conditions (e.g., pressing force and temperature). However, it is said that generally about ±0.5% of shrinkage errors are common.

In order to solve the above-mentioned problem, such a process of producing the multilayered ceramic substrate is proposed that the firing shrinkage does not occur in a planar direction (namely, in a direction parallel to the plane of the substrate).

In the United States Patent Nos. 4,753,694 and 4,879,156, a method of producing a multilayered ceramic substrate having solid metal electrodes in place of thick film conductors with high resistance. This method comprises depositing solid electrode patterns such as copper foils onto carrier films, transferring said solid electrode patterns to green sheets, carrying out a via hole processing to the green sheets, laminating a plurality of the green sheets, and sintering the laminated green sheets while being pressed by porous sintered plates in a metal die. According to this method, the planar shrinkage is suppressed and the shrinkage in a direction of thickness is produced by pressing. However, in this method, the following problems are encountered. That is, since the sintered plate must be porous so as to burn off a binder completely at the time of the sintering process, it sticks together at the time of sintering and is difficult to be detached. Furthermore, since it is necessary to fire during a period when the green sheets are pressed, a firing furnace is complicated and not suitable for mass production.

In the United States Patent No. 5,085,720, a method of reducing X-Y shrinkages during firing of a ceramic green body is disclosed. In this method, a release layer, which becomes porous during firing, is placed upon the ceramic body and the assemblage is fired while maintaining a pressure on the assemblage

EP 0 591 733 A1

in a direction normal to the body surface, thereby to eliminate the X-Y firing shrinkage of the ceramic body during firing.

Also in Japanese Laid-Open Patent Publication No. H 4-243978, a method of reducing X-Y shrinkage of the ceramic green body during firing is disclosed. This method comprises the steps of applying a flexible release layer to a surface of a ceramic green body, firing the assemblage of the ceramic green body and the release layer, cooling the sintered assemblage and removing the porous release layer from the surface of the sintered ceramic body. In this method, the ceramic body needs not be pressed during the firing step.

In the United States Patent No. 5,130,067, a method of controlling X-Y shrinkage and reducing X-Y distortion of the multilayered ceramic substrate is disclosed. This method discloses that, by laminating a porous green sheet on a ceramic body, the firing shrinkage of the ceramic body in the X-Y direction is eliminated. The porous layer which is not sintered is removed after the firing.

In the above-mentioned methods, though shrinkages of the ceramic substrate in the planar direction during the firing can be reduced, it is still problematic in that a warpage or distortion frequently occurs at a corner portion of the ceramic substrate.

This is the common problem for the process including the firing of ceramics and glass-ceramics not limited to the multilayered substrate. In such substrate that the substrate material shrinks only in a direction of thickness and shrinkage in the planar direction is zero, if the substrate warp during the firing can be reduced it is very effective from the industrial point of view.

## OBJECT AND SUMMARY OF THE INVENTION

It is an object of the present invention to provide a method for producing a multilayered ceramic substrate having a highly precise dimensional stability, in which there is little shrinkage in a planar direction or substrate warps.

It is another object of the present invention to provide a method for producing a multilayered ceramic substrate which can be fired without pressing in a firing step, and in which shrinkage is occurred only in a direction of thickness but shrinkage in the planar direction is eliminated.

In order to achieve the above-mentioned objects, a method for producing the multilayered ceramic substrate of the present invention comprises the steps:

making a first green sheet containing at least a glass-ceramic inorganic powder containing 30 -- 100 parts by weight glass powder and 70 -- 0 parts by weight ceramic powder, an organic binder and a plasticizer,

forming an electrode pattern and an interlayer connecting via on and in the first green sheet by a conductor paste,

laminating a plurality of the first green sheets to form a glass-ceramic green sheet laminate,

making a second green sheet containing at least a ceramic powder which is not sinterable at a sintering temperature of the glass-ceramic inorganic powder, an organic binder and a plasticizer, thickness of the second green sheet being 0.1 times or more of the thickness of the green sheet laminate,

placing the second green sheets on both faces of the glass-ceramic green sheet laminate, to form a green sheet assemblage,

firing the green sheet assemblage to burn off the organic binders in the first green sheets and in the second green sheets and to sinter of the glass-ceramic inorganic powder in such a temperature range that the glass-ceramic inorganic powder is sintered and the ceramic powder is not sintered, and

removing ceramic powder residue in the fired second green sheet.

In a preferred embodiment of the present invention, the firing temperature is in a range of from 800°C to 1000°C.

A mean particle size of the ceramic powder in the second green sheet is preferably in a range of from 0.5μm to 20μm.

A conductor paste utilized in the present invention may be comprising of organic binder and at least one of Ag, Ag-Pd, Ag-Pt or Cu.

In another embodiment of the present invention,

the conductor paste includes cupric oxide as host material,

and firing includes,

decomposing burning off the organic binders in green sheet assemblage under an oxygen sufficient atmosphere at a temperature lower than the sintering temperature of the glass-ceramic inorganic powder,

reducing the cupric oxide in the conductor paste to copper under an atmosphere of hydrogen gas or a mixture of hydrogen and nitrogen, and

sintering the glass-ceramic inorganic powder under a nitrogen atmosphere.

4

The glass-ceramic inorganic powder in the present invention may include a case in which content of the ceramic powder is zero.

In the present invention, by the aforementioned processes, a multilayered substrate, in which the glass-ceramic substrate shrinks only in a direction of thickness and does not shrink in a planar direction during the firing, and the substrate does not warp, can be obtained.

It is believed that, since the non-sinterable materials are laminated on both faces of the glass-ceramic substrate, the shrinkage of the glass-ceramic substrate in the planar direction is prevented. Also, by making the thickness of the non-sinterable material layer 0.1 times or more of the thickness of the glass-ceramic green sheet laminate, the warp of the glass-ceramic substrate is reduced. By removing the unnecessary non-sinterable material after firing the substrate, a desired multilayered substrate is obtained without the planar shrinkage.

While the novel features of the invention are set forth particularly in the appended claims, the invention, both as to organization and content, will be better understood and appreciated, along with other objects and features thereof, from the following detailed description taken in conjunction with the drawings.

## BRIEF DESCRIPTION OF THE DRAWINGS

FIG. 1 is a sectional view showing a assemblage of a glass-ceramic green sheet laminate for a multilayered ceramic substrate and ceramic green sheets of the present invention.

FIG. 2 is a flow chart showing a production process of the present invention.

FIG. 3 is a side view schematically showing a substrate warping state after firing a glass-ceramic green sheet laminate.

It will be recognized that some or all of the Figures are schematic representations for purposes of illustration and do not necessarily depict the actual relative sizes or locations of the elements shown.

## DESCRIPTION OF THE PREFERRED EMBODIMENTS

In the following, a method for producing a multilayered ceramic substrate of the present invention which does not shrink in a planar direction is described with reference to the drawings.

《Example 1》

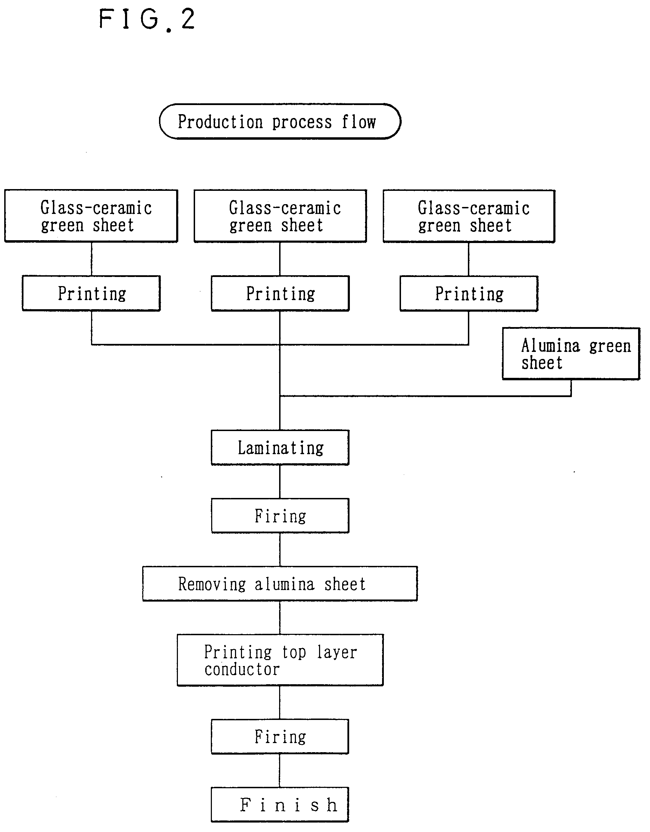

First, a method for producing a multilayered ceramic substrate is described with reference to a flow chart of FIG. 2.

A mixture (made by Nippon Electric Glass Co. MLS-19) of an alumina powder as a ceramic material and a lead borosilicate glass powder at a weight ratio of 50:50 is used as a glass-ceramic inorganic component of substrate materials. Polyvinyl butyral as an organic binder, di-n-butyl phthalate as a plasticizer and a mixed solution (30:70 by weight) of toluene and isopropyl alcohol as a solvent are added to the glass-ceramic inorganic component, and mixed well to obtain a slurry.

The slurry is formed into a sheet on an organic film by doctor blading. Respective processes of doctor blading, drying, punching and, when necessary, via hole processing are performed in sequence by a combined work system. A first green sheet or glass-ceramic green sheet thus prepared is subjected to conductor patterning and via hole filling by screen printing method using conductor pastes. The conductor paste utilized for conductor patterning is a silver paste prepared by, adding a vehicle composed of ethyl cellulose as an organic binder dissolved in terpineol, to inorganic components prepared by adding 5 wt% of glass frit (made by Nippon Electric Glass Co. GA-9 glass powders, with mean particle size: 2.5 $\mu$m) for obtaining an adhesion strength to a Ag powder (mean particle size: 1 $\mu$m), and mixing in roll-mill rolls to have an adequate viscosity. And the conductor paste used for via hole filling is a silver paste prepared by adding 15 weight % of glass-ceramic powders as the inorganic component to the above silver paste.

Next, a second or an alumina green sheet, which will not sinter at the predetermined firing temperature, is prepared in the same manner as that in the glass-ceramic green sheet for glass-ceramic substrate except for that only the alumina powder (made by Sumitomo Chemical Co. ALM-41, mean particle size: 1.9 $\mu$m) is used as the inorganic component. The thickness of the first green sheet for substrate is about 200 $\mu$m and that of the second green sheet is about 300 $\mu$m.

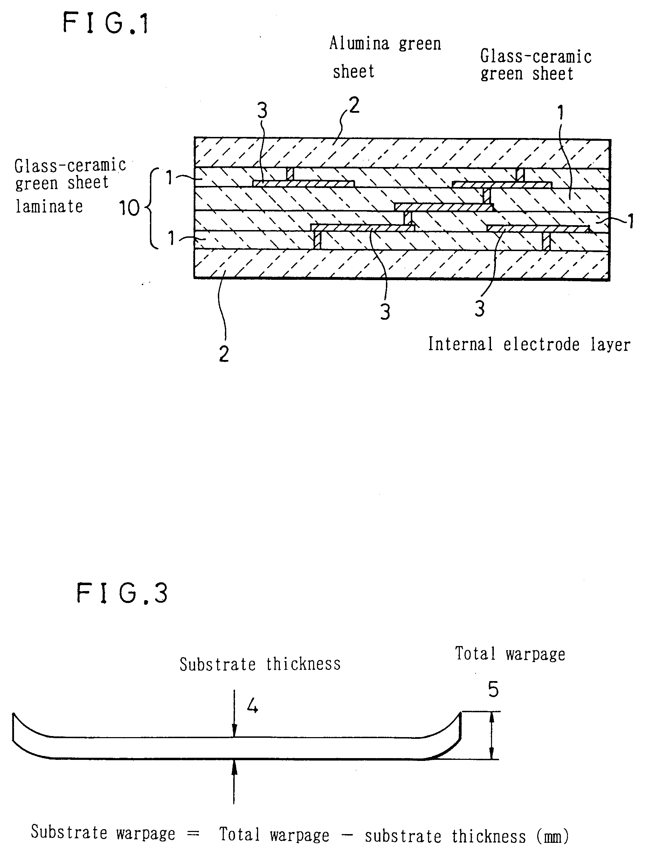

Five sheets of the first green sheets having printed silver paste are punched and stacked to form a glass-ceramic green sheet laminate. And further, the second green sheets are overlapped on both faces of the above laminate to form a green sheet assemblage. The assemblage is then pressed at a temperature of 80 °C and a pressure of 200 kg/cm$^2$. The configuration of the thus heat-pressed assemblage is shown in FIG. 1. Numeral 1 designates each glass-ceramic green sheet or the first green sheet consisting of the aforementioned substrate materials, numeral 2 designates an alumina green sheet or the second green sheet, numeral 10 designates the glass-ceramic green sheet laminate, and numeral 3 designates an internal electrode layer of the conductor paste. The internal electrode layers comprise electrode patterns and interlayer connecting vias.

Next, the assemblage is placed on an alumina plate and fired in air after the binder burn-off processing. Conditions are as follows: the binder burn-off is performed by holding the assemblage in a batch furnace kept at a temperature of 500°C in air for two hours after rising of temperature at a rate of 100°C/hour, and the firing is performed in an electric belt furnace at a temperature of from 850°C to 1100°C in air for one hour. (A maximum temperature retaining time is about 12 minutes.)

Then, the sintered assemblage is dipped into a butyl acetate solvent and subjected to ultrasonic washing. As a result, the alumina residue in the fired alumina green sheets on both faces of the fired glass-ceramic green sheet laminate can be removed completely. Result of measurement on shrinkage of the resultant sintered glass-ceramic substrate are shown in Table 1.

Table 1

| Amount of glass (wt%) | Amount of alumina (wt%) | Firing temperature (°C) | Shrinkage lateral (%) | Note |
|---|---|---|---|---|
| 10 | 90 | 1100 | -- | Cracks in substrate |
| 20 | 80 | 1000 | -- | Cracks in substrate |
| 30 | 70 | 1000 | 0.45 | |
| 45 | 55 | 900 | 0.12 | |
| 60 | 40 | 900 | 0.13 | |
| 80 | 20 | 850 | 0.09 | |
| 90 | 10 | 850 | 0.12 | |
| 100 | 0 | 850 | 0.06 | |

As it is apparent from Table 1, in a region containing a large amount of alumina (more than 80% alumina) as the ceramic component in the glass-ceramic inorganic component, the lateral shrinkage can not be suppressed and cracks are produced in the substrate. It is believed that, this is caused only in the process of the present invention, wherein the substrate material containing some glass components is used, and that the shrinkage is produced only in the direction of thickness probably owing to softening and melting of the glass in the firing step. Next, when observing the laminate, it is understood that the shrinkage of the substrate in the planar direction is suppressed in the region containing 30 weight % or more of glass. Though the shrinkage in the planar direction can be suppressed when the glass component in the glass-ceramic inorganic component is 30 weight % or above, for obtaining a satisfactory results a glass contents of 45 weight % or more is preferable.

Then, a top layer pattern is screen-printed on the multilayered substrate by silver • palladium pastes, and fired after drying in a same manner as aforementioned. Since the shrinkage of an internal substrate is very little, there is little printing discrepancy in the top layer pattern.

《Example 2》

Next, the thickness of the alumina green sheet (second green sheet) used for suppressing the shrinkage of the glass-ceramic layer in the planar direction is examined.

For evaluations, the same alumina powder and glass-ceramic inorganic powder as Example 1 are used.

Experiments are evaluated for two cases, a first case of changing the thickness of the alumina green sheet while keeping the laminate thickness of the substrate materials constant, and a second case of changing the laminate thickness of the substrate materials while keeping the thickness of the alumina green sheet constant as shown in Table 2. Conditions for producing the substrate are as follows.

On the glass-ceramic green sheet prepared in the same manner as that in Example 1, conductor patterning and via hole filling are performed by screen-printing using CuO pastes. The CuO paste utilized for conductor patterning is prepared by, adding a vehicle composed of ethyl cellulose as an organic binder dissolved in terpineol, to inorganic components prepared by adding 3 wt% of glass frit (made by Nippon Electric Glass Co. LS-0803 glass powders, mean particle size: 2.5 $\mu$m) for obtaining an adhesion strength to a CuO powder (mean particle size: 3 $\mu$m), and mixing in roll-mill rolls to have an adequate viscosity.

The CuO paste utilized for making via hole filling is prepared by adding 15 weight % of glass-ceramic powder as the inorganic components to the paste used for the conductor patterning.

The alumina green sheet which does not contain the glass frit and does not sinter is prepared in the same manner as that in Example 1. The thickness of the first or glass-ceramic green sheet for substrate is about 250 $\mu$m, and the second or alumina green sheets having various thickness are made by changing a doctor blade thickness in the doctor blading.

A predetermined number of green sheets for substrate having printed conductor pastes thereon are punched, stacked to obtain the thickness shown in Table 2, and further thereon the punched alumina green sheets are placed on both faces. A laminated assemblage is then pressed at a temperature of 80°C and a pressure of 200 kg/cm$^2$.

Next, the firing process is as follows: First, a binder burn off step is described. The organic binders contained in the green sheet and the CuO paste are polyvinyl butyrol and ethyl cellulose respectively. Thus, since decomposition temperature of the binder in air above 500°C is acceptable, the binder burn off is carried out at a temperature of 600°C. Thereafter, the laminated assemblage is reduced in a 100% hydrogen gas atmosphere at a temperature of 200°C for 5 hours. By analyzing the resultant Cu layer by X-ray diffraction, it is confirmed as 100% Cu. It is believed that, since the binder burn off process is completed and hence the glass-ceramic layer and the alumina layer remain porous, the conductor pastes in the internal substrate layer have also been reduced easily into metal copper.

Next, the sintering step is performed in a pure nitrogen gas atmosphere at a temperature of 900°C in a continuous belt furnace.

Alumina layers on both faces of the fired glass-ceramic green sheet laminate prepared in the above-mentioned manner are removed by ultrasonic washing as same as Example 1, and performances of the substrate are evaluated. Results are similarly shown in Table 2.

Table 2

| Thickness of the first green sheet laminate A (mm) | Thickness of the second green sheet B (mm) | Thickness ratio B/A | Thickness of substrate after firing (mm) | Firing temperature (°C) | Shrinkage (%) | Warpage of substrate (mm) |
|---|---|---|---|---|---|---|
| 0.8 | 0.05 | 0.0625 | 0.52 | 900 | 0.48 | 1.95 |
| 0.8 | 0.12 | 0.15 | 0.52 | 900 | 0.21 | 0.35 |
| 0.8 | 0.2 | 0.25 | 0.52 | 900 | 0.24 | 0.21 |
| 0.8 | 0.4 | 0.5 | 0.52 | 900 | 0.20 | 0.25 |
| 0.8 | 0.8 | 1.0 | 0.52 | 900 | 0.18 | 0.22 |
| 0.6 | 0.2 | 0.333 | 0.39 | 900 | 0.10 | 0.01 |
| 1.0 | 0.2 | 0.2 | 0.65 | 900 | 0.13 | 0.12 |
| 1.4 | 0.2 | 0.143 | 0.91 | 900 | 0.16 | 0.15 |
| 1.8 | 0.2 | 0.111 | 1.18 | 900 | 0.21 | 0.25 |
| 2.2 | 0.2 | 0.091 | 1.43 | 900 | 0.25 | 0.55 |
| 2.6 | 0.2 | 0.077 | 1.68 | 900 | 0.23 | 2.26 |

As it is apparent from the results, in case the thickness of the second green sheet i.e., the alumina green sheet for suppressing the planar direction shrinkage is thinner against the thickness of the glass-ceramic green sheet laminate, not only the shrinkage in the planar direction is larger but also the resultant substrate warpage is large. The reason is that, when the ratio of thickness of each alumina green sheet to the thickness of the glass-ceramic green sheet laminate is 0.0625 or below, shrinkage of the accumulated substrate becomes difficult to be suppressed and warpage of the substrate occurs.

EP 0 591 733 A1

Next, experiments are performed by keeping the thickness of the alumina green sheet constant, and changing the number of laminates of the glass-ceramic green sheet for changing the thickness of the glass-ceramic green sheet laminate. As the result, it is understood that, also in this case, the thickness of each alumina green sheet is 0.091 times of or below to the thickness of the glass-ceramic green sheet laminate, and in such case the resultant substrate warps largely.

From the above results, it is apparent that, the ratio of the thickness of each second green sheet for suppressing the shrinkage in the both faces used in the production process of the present invention must be 0.1 or more, to the thickness of the glass-ceramic green sheet laminate, in order to suppress the shrinkage in the planar direction.

In this example, though $Al_2O_3$ is used as the non-sinterable material, the same result is also obtained by using MgO, $ZrO_2$, $TiO_2$, BN and BeO. Though the above-mentioned embodiment shows one glass-ceramic green sheet laminate and the two non-sinterable green sheets are laminated, the same result is obtainable in other embodiment. For instance, an alternate lamination of the glass-ceramic green sheet laminates and the ceramic green sheets gives the same result. That is, by this method, a plurality of substrates without warpage can be obtained at the same time, when the ratio of thickness of the non-sinterable green sheet to that of the glass-ceramic green sheet laminate is 0.1 or above.

Though the conductor pattern of the top layer is formed after firing the substrate, it is to be understood that the same result is obtained by a method in which a top conductor pattern of paste is printed on the green sheet and firings of the paste and the green sheet are carried out simultaneously.

《Example 3》

Next, substrate performances in the case of changing mean particle sizes of alumina utilized for the alumina green sheet for suppressing the shrinkage are evaluated.

Glass-ceramic green sheets for substrate are prepared in the same manner as that in Example 1 except for that a mixture of glass and ceramic with a ratio glass/ceramic of 45 wt%/55 wt% (made by Nippon Electric Glass Co. MLS-19, mean particle size: 1.8 $\mu$m) is used as glass-ceramic for substrate material. Then, as same as Example 1, on the glass-ceramic green sheet, the conductor patterning and via hole filling are performed by screen printing using silver pastes. The conductor pastes used for conductor patterning and via hole filling are the same as those used in Example 1.

Next, the alumina green sheet which will not sinter is prepared in the same manner as that in Example 1 except for that alumina powders with various mean particle sizes of from 0.1 $\mu$m to 33.0 $\mu$m are used as is shown in Table 3, and that, the amount of binder is somewhat changed responsive to the alumina particle sizes. The thickness of the glass-ceramic green sheet for substrate is about 200 $\mu$m and that of the alumina green sheet is about 300 $\mu$m.

Five sheets of the glass-ceramic green sheets having conductor pastes are punched and stacked, and further, the alumina green sheets are punched and overlapped on both faces thereof. The obtained assemblage is pressed at a temperature of 80°C and a pressure of 200 kg/cm$^2$.

Next, the assemblage is placed on an alumina plate and fired in air after the binder burn off processing. Conditions are as follows: the binder burn off is performed in air by holding in a batch furnace at a temperature of 500°C for two hours, and the firing is performed in an electric belt furnace at a temperature of 900°C in air for one hour. (A maximum temperature retaining time is about 12 minutes.) Then, the fired assemblage is dipped into a butyl acetate solvent and subjected to ultrasonic washing, as a result, the alumina powder residue on both faces of the glass-ceramic substrate can be removed completely, and the sintered glass-ceramic substrate is obtained.

Shrinkages in the planar direction, the surface roughness and warpage of the sintered glass-ceramic substrate thus obtained are measured. Further, the adhesion strength of a Ag-Pd conductor printed and fired on the surface of the obtained sintered substrate are measured. Results are shown in Table 3.

8

Table 3

| Mean particle size of alumina in the second green sheet (μm) | Substrate material glass/ceramic (weight ratio) | Firing temperature (°C) | Shrinkage (%) | Surface roughness (μm) | Substrate warpage (mm) | Conductor adhesion strength (kgf) | Note |
|---|---|---|---|---|---|---|---|
| 0.1 | 45/55 | 900 | 1.20 | ±0.36 | 0.22 | 2.20 | |
| 0.5 | 45/55 | 900 | 0.51 | ±0.67 | 0.32 | 2.05 | |
| 1.8 | 45/55 | 900 | 0.12 | ±1.15 | 0.15 | 2.80 | |
| 3.0 | 45/55 | 900 | 0.10 | ±1.35 | 0.19 | 2.65 | |
| 7.0 | 45/55 | 900 | 0.05 | ±2.10 | 0.24 | 2.55 | |
| 12.0 | 45/55 | 900 | 0.14 | ±4.30 | 0.24 | 2.24 | |
| 20.0 | 45/55 | 900 | 0.18 | ±11.3 | 0.09 | 2.35 | |
| 33.0 | 45/55 | 900 | 0.06 | ±26.0 | 0.29 | 2.01 | Poor printing |

Evaluations of the experiments are as follows. The shrinkages shown in Table 3 in the planar direction is defined as the changes in linear distance between two selected via holes (150 $\mu$m diameter) as a result of firing. The surface roughness is measured by a surface roughness meter. The substrate warpage is evaluated by a method shown in FIG. 3. In FIG. 3, the substrate warpage is a value obtained by subtracting the thickness 5 of the substrate from the total warpage 6. In the process of the present invention, the substrate warpage is hardly eliminated completely, it is good for use, when the warpage is 0.3 mm or below, and preferably 0.2 mm or below. The conductor adhesion strength is measured in the following manner. As same as Example 1, the conductor pattern of the top layer is formed by screen-printing on the surface of the multilayered sintered substrate using the silver • palladium paste, and fired at a temperature of 860°C after drying at a temperature of 120°C for 10 minutes. (A maximum temperature retaining time is 6 minutes, a continuous belt furnace requiring 3 minutes from charging till take out is used.) Then, a conductor wire (diameter: 0.6 mm) of phosphor bronze bent in an L shape is soldered onto the surface of the above conductor pattern (2 mm square) and pulled perpendicularly to the substrate, and the strength is measured by a tension tester until the puncture occurs.

As the result of evaluations, it is understood that, the shrinkages in the planar direction is suppressed even in the case of changing the alumina particle sizes. However, in the case of small alumina particle size of 0.1 μm, the shrinkage is somewhat large. This is believed that, since a large amount of binder is required for obtaining the ceramic green sheet in the case of small alumina particle size. In the case of 0.1 μm alumina, 15 wt% of binder is required, while such a low value of 9 wt% is sufficient for the 1.8 μm alumina. The required amount of binder increases as the particle size of alumina decreases. When the amount of binder is large, a particle density of the sheet after the binder burn off decreases and a suppressing force for suppressing the shrinkage in the planar direction is weakened in the firing step. Therefore, the mean particle size of alumina is preferably 0.5 μm or above.

Next, as the result of evaluations on the surface roughness, it is understood that there is an interrelation with the alumina particle size being used, the smaller the alumina particle size the smaller the surface roughness. It is believed that, even after removing the alumina residue on both faces of the sintered substrate by the ultrasonic washing, a part of alumina is stuck to the glass of the substrate and remained. Thus, alumina with mean particle sizes of 33 μm or more, which produces the substrate having surface roughness of 20 μm or more, is problematic in practical use.

Next, the substrate warpage is within a variation range independent of the alumina particle sizes. Finally, adhesion strength of the conductor tends to be intensified above the mean particle sizes of 1.8 μm. In comparison with the adhesion strength of about 2 kgf in the case of usual firing of the same substrate material, a large value is shown as the strength in the process of the present invention. It is believed that, since the surface roughness is adequately large as shown from the Table 3, the adhesion strength is improved by an anchor effect.

From the above results, it is understood that, the particle size of alumina as the inorganic component of the ceramic green sheet, which is non-sinterable, is preferably within the range of from 0.5 μm to 20.0 μm, meanwhile, from the viewpoint of practical use, the mean particle size is most preferably within the range of from 1.8 μm to 7 μm.

Although the present invention has been described in terms of the presently preferred embodiments, it is to be understood that such disclosure is not to be interpreted as limiting. Various alterations and modifications will no doubt become apparent to those skilled in the art to which the present invention pertains, after having read the above disclosure. Accordingly, it is intended that the appended claims be interpreted as covering all alterations and modifications as fall within the true spirit and scope of the invention.

**Claims**

1. A method for producing a multilayered ceramic substrate comprising the steps:

   making a first green sheet containing at least a glass-ceramic inorganic powder containing 30 -- 100 parts by weight glass powder and 70 -- 0 parts by weight ceramic powder, an organic binder and a plasticizer,

   forming an electrode pattern and an interlayer connecting via on and in said first green sheet by a conductor paste,

   laminating a plurality of said first green sheets to form a glass-ceramic green sheet laminate,

   making a second green sheet containing at least a ceramic powder which is not sinterable at a sintering temperature of said glass-ceramic inorganic powder, an organic binder and a plasticizer, thickness of said second green sheet being 0.1 time or more of the thickness of said green sheet laminate,

   placing said second green sheets on both faces of said green sheet laminate, to form a green sheet assemblage,

   firing said green sheet assemblage to burn off said organic binders in said first green sheets and in said second green sheets and to sinter of said glass-ceramic inorganic powder in such a temperature range that said glass-ceramic inorganic powder is sintered and said ceramic powder is not sintered, and
removing ceramic powder residue in said fired second green sheet.

2. The method of claim 1, wherein:
said sintering temperature of said glass-ceramic inorganic powder is in a range of from 800 °C to 1000 °C.

3. The method of claim 1, wherein:
a mean particle size of said ceramic powder in said second green sheet is in a range of from 0.5 μm to 20 μm.

4. The method of claim 1, wherein:
said removing is carried out by ultrasonic washing.

5. The method of claim 1, wherein:
said conductor paste contains at least one of Ag, Ag-Pd, Ag-Pt or Cu as host material.

6. The method of claim 1, wherein:
said conductor paste includes cupric oxide as host material,
said firing includes:
decomposing and burning off said organic binders in said green sheet assemblage at a temperature lower than said sintering temperature of said glass-ceramic inorganic powder,
reducing said cupric oxide in conductor paste to copper under an atmosphere of hydrogen gas or a mixture of hydrogen and nitrogen, and
sintering said glass-ceramic inorganic powder under a nitrogen atmosphere.

# FIG.1

Alumina green
sheet

Glass-ceramic
green sheet

3    2                    1

Glass-ceramic
green sheet
laminate    10 { 1

1

1

Internal electrode layer

3    3

2

2

# FIG.3

Substrate thickness

Total warpage

4

5

Substrate warpage = Total warpage − substrate thickness (mm)

12

# FIG.2

```
                  ┌──────────────────────────────┐
                  │  Production process flow      │
                  └──────────────────────────────┘

┌──────────────┐   ┌──────────────┐   ┌──────────────┐
│ Glass-ceramic│   │ Glass-ceramic│   │ Glass-ceramic│
│ green sheet  │   │ green sheet  │   │ green sheet  │
└──────┬───────┘   └──────┬───────┘   └──────┬───────┘
       │                  │                  │
   ┌───┴────┐         ┌───┴────┐         ┌───┴────┐
   │Printing│         │Printing│         │Printing│
   └───┬────┘         └───┬────┘         └───┬────┘
                                            │      ┌──────────────┐
                                            │      │Alumina green │
                                            │      │sheet         │
                                            │      └──────┬───────┘
                              ┌─────────────┴────┐
                              │   Laminating     │
                              └─────────┬────────┘
                              ┌─────────┴────────┐
                              │     Firing       │
                              └─────────┬────────┘
                        ┌───────────────┴──────────┐
                        │ Removing alumina sheet    │
                        └───────────────┬──────────┘
                        ┌───────────────┴──────────┐
                        │ Printing top layer        │
                        │ conductor                 │
                        └───────────────┬──────────┘
                              ┌─────────┴────────┐
                              │     Firing       │
                              └─────────┬────────┘
                              ┌─────────┴────────┐
                              │   F i n i s h    │
                              └──────────────────┘
```

13

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| P,X | EP-A-0 535 711 (MATSUSHITA ELECTRIC IND CO LTD) 7 April 1993<br>* page 5, line 14 - line 44 *<br>* page 6, line 37 - page 7, line 12 * | 1-6 | H01L21/48<br>H05K3/46 |
| D,A | EP-A-0 479 219 (E.I. DU PONT DE NEMOURS & COMPANY INCORPORATED)<br>* the whole document * | 1-3,5 | |
| A | EP-A-0 332 457 (MATSUSHITA ELECTRIC IND CO LTD)<br>* page 3, line 46 - page 4, line 11 * | 1,2,6 | |
| A | EP-A-0 374 825 (W.R. GRACE & CO.-CONN.)<br>* the whole document * | 1-5 | |
| A | PATENT ABSTRACTS OF JAPAN<br>vol. 16, no. 174 (E-1195)27 April 1992<br>& JP-A-04 017 392 (HITACHI LTD)<br>* abstract * | 1 | |

TECHNICAL FIELDS
SEARCHED     (Int.Cl.5)

H01L
H05K

The present search report has been drawn up for all claims

| Place of search | Date of completion of the search | Examiner |
|---|---|---|
| THE HAGUE | 19 November 1993 | DE LAERE, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)